# EUROPÄISCHE PATENTSCHRIFT

(11) **EP 2 013 920 B1**
(45) Veröffentlichungstag und Bekanntmachung des Hinweises auf die Patenterteilung: **06.04.2011**
(21) Anmeldenummer: 07728446.1
(22) Anmeldetag: 24.04.2007
(51) Int. Cl.: H01L 41/04, H01L 41/22, C23C 24/04

(54) **PIEZOAKTOR MIT GRADIENT-VERKAPSELUNGSSCHICHT UND VERFAHREN ZU SEINER HERSTELLUNG**
PIEZOELECTRIC ACTUATOR WITH GRADIENT ENCAPSULATION LAYER AND METHOD FOR THE PRODUCTION THEREOF
ACTIVATEUR PIÉZOÉLECTRIQUE AVEC UNE COUCHE D'ENCAPSULATION À GRADIENT ET SON PROCÉDÉ DE FABRICATION

(30) Priorität: 28.04.2006 DE 102006019900
(43) Veröffentlichungstag der Anmeldung: 14.01.2009
(73) Patentinhaber: SIEMENS AKTIENGESELLSCHAFT, 80333 München (DE)
(72) Erfinder: BAYER, Heiner, 82140 Olching (DE); FREUDENBERG, Hellmut, 93080 Grossberg (DE); GANSTER, Axel, 84419 Schwindegg (DE); HAMANN, Christoph, 93107 Thalmassing (DE); HENNIG, Oliver, 81543 München (DE); JENSEN, Jens, Dahl, 14050 Berlin (DE); LUGERT, Günter, 80804 München (DE); MOCK, Randolf, 85662 Hohenbrunn (DE); SCHUH, Carsten, 85598 Baldham (DE)
(86) Internationale Anmeldenummer: PCT/EP2007/053990
(87) Internationale Veröffentlichungsnummer: WO 2007/125059

(56) Entgegenhaltungen:
- WO-A-01/48834
- DE-A1- 10 164 246
- JP-A- 1 137 686
- JP-A- 2 094 680
- JP-A- 2001 102 649
- US-A1- 2004 043 230

## Beschreibung

### 1. Gebiet der Erfindung

Die vorliegende Erfindung betrifft ein Herstellungsverfahren einer Gradient-Verkapselungsschicht eines Piezoaktors sowie einen Piezoaktor mit Gradient-Verkapselungsschicht.

### 2. Hintergrund der Erfindung

In den letzten Jahren hat die Nachfrage nach piezokeramischen Aktoren oder kurz Piezoaktoren auf Grund ihrer zunehmenden Nutzung, beispielsweise in den neuesten Diesel-Einspritzsystemen der Automobilindustrie, enorm zugenommen. Diese Nachfrage unterstützt ebenfalls die Entwicklung von Piezoaktoren. In mehreren neuen Einspritz- bzw. Injektorkonstruktionen sollen die Piezoaktoren komplett von Dieselkraftstoff umgeben sein. Diese Art der Konstruktion der Einspritzanlagen bezeichnet man auch als "wet design".

Da die Piezoaktoren bei einem direkten Kontakt mit verunreinigtem oder durch Additive modifiziertem Dieselkraftstoff chemisch und elektrisch angegriffen werden, muss eine entsprechende Schutzhülle für den Piezoaktor bereitgestellt werden. Diese Schutzhülle sollte sowohl eine elektrische Isolation gegen einen möglichen Kurzschluss durch den elektrisch leitenden Kraftstoff als auch eine chemische Isolation gegen den Angriff des umgebenden Kraftstoffs auf die Bestandteile des Piezoaktors bereitstellen.

Im Stand der Technik sind Metallgehäuse unterschiedlicher Konstruktion bekannt, die den Piezoaktor umgeben. Ein Beispiel für ein derartiges Metallgehäuse ist ein Wellrohr. Die Metallgehäuse sind mit geeigneten flüssigen Füllmaterialien gefüllt, um eine Übertragung des durch den Kraftstoff augebrachten Drucks auf den innen liegenden Piezoaktor zu realisieren. Diese konstruktive Lösung hat jedoch die Nachtteile, dass sie aufwendig in ihrer Herstellung und platzintensiv ist.

Aus der WO 01/48834 A ist ein piezoelektrischer (Vielschicht-)Aktor mit einer Verkapselung bestehend aus einer Schicht aus Parylene und einer zusätzlichen Metallschicht bekannt.

Es ist daher das Problem der vorliegenden Erfindung, einen Schutz für einen Piezoaktor bereitzustellen, der eine verlässliche elektrische und chemische Isolation des Piezoaktors gegen äußere Einflüsse gewährleistet.

### 3. Zusammenfassung der Erfindung

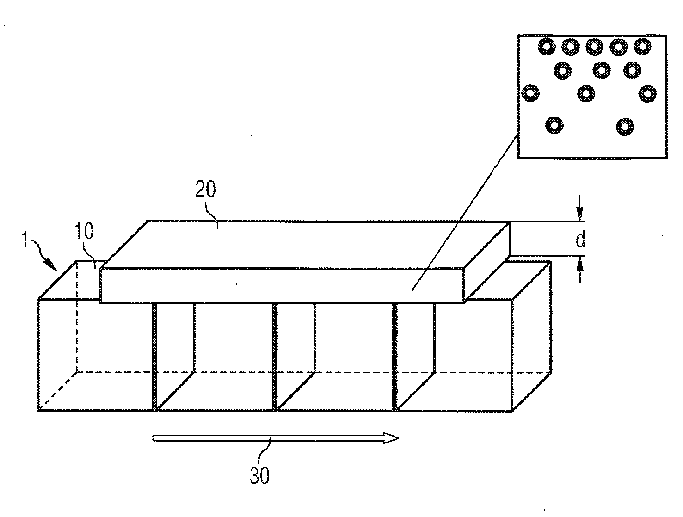

Das obige Problem wird durch ein Herstellungsverfahren einer Gradient-Verkapselungsschicht eines Piezoaktors gemäß dem unabhängigen Patentanspruch 1 sowie durch einen Piezoaktor mit Gradient-Verkapselungsschicht gemäß dem unabhängigen Patentanspruch 6 gelöst. Weiterentwicklungen und Vorteile der vorliegenden Erfindung gehen aus der folgenden Beschreibung, der Zeichnung und den anhängenden Patentansprüchen hervor.

Das obige Herstellungsverfahren erzeugt eine Gradient-Verkapselungsschicht eines Piezoaktors, so dass der Piezoaktor ohne zusätzliche gehäuseartige umhüllende Struktur nach außen geschützt ist. Dieses Herstellungsverfahren weist die folgenden Schritte auf: a) Beladen eines ersten Pulverförderers mit ersten Partikeln aus einem ersten Werkstoff, der gegenüber einem ausgewählten Medium chemisch resistent ist, b) Beladen eines zweiten Pulverförderers mit zweiten Partikeln aus einem zweiten Werkstoff, der elastische Materialeigenschaften besitzt, und c) thermisches Spritzen, insbesondere Kaltgasspritzen, der ersten und zweiten Partikel mit Hilfe des ersten und zweiten Pulverförderers auf eine Oberfläche des Piezoaktors derart, dass die Gradient-Verkapselungsschicht entsteht.

Das erfindungsgemäße Verfahren arbeitet mit einem thermischen Spritzverfahren, insbesondere dem Kaltgasspritzen. Bei diesem Verfahren erfolgt kein Aufschmelzen des Beschichtungsmaterials vor dem Aufbringen auf die entsprechende Oberfläche. Stattdessen werden Pulverpartikel unterschiedlicher Werkstoffe mit hoher kinetischer Energie auf die zu beschichtende Oberfläche gespritzt. Beim Aufschlagen der einzelnen Partikel auf der Oberfläche entsteht für jedes einzelne Partikel eine lokale Schweiß-/Schmelzzone. Während die kaltgasgespritzten Partikel eine Schicht auf der Oberfläche des Piezoaktors bilden, werden die Eigenschaften des Ausgangsmaterials nicht oder nur wenig verändert. Daher werden zur Erzeugung der Gradient-Verkapselungsschicht auf dem Piezoaktor Partikel unterschiedlicher Werkstoffe oder Werkstoffzusammensetzungen aufgebracht, so dass innerhalb der Gradient-Verkapselungsschicht gezielt physikalische und/oder chemische Eigenschaften der Gradient-Verkapselungsschicht einstellbar sind. Während des Aufbringens der Gradient-Verkapselungsschicht verändert man den Anteil unterschiedlicher Partikel, wodurch sich in unterschiedlichen Schichttiefen der Gradient-Verkapselungsschicht bzw. in unterschiedlichen Entfernungen zur Oberfläche des Piezoaktors innerhalb dieser Schicht unterschiedliche physikalische und/oder chemische Eigenschaften ergeben.

Gemäß einer Ausführungsform des Herstellungsverfahrens erfolgt ein Verändern eines Anteils an ersten Partikeln und/oder eines Anteils an zweiten Partikeln während des Kaltgasspritzens, so dass in der Gradient-Verkapselungsschicht in Abhängigkeit von deren Schichtdicke eine chemische und/oder physikalische Materialeigenschaft der ersten und/oder zweiten Partikel eine chemische und/oder physikalische Schichteigenschaft bestimmt und sich diese Schichteigenschaft mit der Schichtdicke der Gradient-Verkapselungsschicht ändert.

Um den Piezoaktor beispielsweise bei einem Einsatz in Dieselkraftstoff unter Hochdruck ausreichend zu schützen, muss die Gradient-Verkapselungsschicht sowohl einen chemischen als auch einen mechanischen Schutz zur Verfügung stellen. Ein chemischer Schutz wird dadurch gewährleistet, dass die Gradient-Verkapselungsschicht angrenzend an umgebenden Dieselkraftstoff einen metallischen Bereich aufweist, der gegen die chemischen Angriffe des Kraftstoffs resistent ist. Einen derartigen metallischen Bereich erzielt man durch das Kaltgasspritzen von Metallpartikeln, vorzugsweise sphärische Metallpartikel.

Um den äußeren metallischen Bereich vor überlastenden Dehnungen aus dem Normalbetrieb des Piezoaktors zu schützen, wird vorzugsweise zwischen Oberfläche des Piezoaktors und metallischem Bereich in der Gradient-Verkapselungsschicht ein Bereich erzeugt, der sich durch eine gute elastische Verformbarkeit auszeichnet. Durch diese elastischen Eigenschaften, wie sie beispielsweise Polymere oder andere Kunststoffe bereitstellen, wird die normale Betriebsdehnung des Piezoaktors mit zunehmender Entfernung von der Oberfläche des Piezoaktors innerhalb der Gradient-Verkapselungsschicht gedämpft, so dass nur ein Bruchteil der Dehnung des Piezoaktors auf den metallischen Bereich der Gradient-Verkapselungsschicht übertragen wird und diesen nicht beschädigt. Ein derartiger elastischer Bereich innerhalb der Gradient-Verkapselungsschicht ist durch das Kaltgasspritzen von Metallpartikeln mit Kunststoffummantelung oder durch das Kaltgasspritzen von Kunststoffpartikeln als zweite Partikel generierbar. Die Metallpartikel mit Kunststoffummantelung werden beispielsweise mit der LBL-Technologie der Firma Capsulution NanoScience AG, Berlin, hergestellt.

Es ist ebenfalls denkbar, die Materialeigenschaften der zweiten Partikel derart einzustellen, dass sie gleichzeitig zu den elastischen Materialeigenschaften auch elektrisch isolierend wirken. Dies wäre geeignet, um die zweiten Partikel direkt auf die Oberfläche des Piezoaktors aufzubringen, so dass ein Kurzschluss zwischen nach außen tretenden Innenelektroden sowie eine negative Beeinflussung, beispielsweise beim Auftreten von Polungsrissen, verhindert ist.

Es ist ebenfalls denkbar, zusätzlich das Kaltgasspritzen von mindestens dritten Partikeln durchzuführen, so dass eine Werkstoffeigenschaft der dritten Partikel in Abhängigkeit von deren Anteil in der Gradient-Verkapselungsschicht gezielt in einem Schichtdicken-Bereich der Gradient-Verkapselungsschicht als Schichteigenschaft generierbar ist.

Der Piezoaktor mit Gradient-Verkapselungsschicht gemäß der vorliegenden Erfindung weist die folgenden Merkmale auf: a) einen Piezoaktor, vorzugsweise einen Vielschichtaktor, b) die auf einer äußeren Oberfläche des Piezoaktors aufgebrachte Gradient-Verkapselungsschicht, die mindestens eine chemische und/oder physikalische Eigenschaft aufweist, die sich mit zunehmender Entfernung von der Oberfläche des Piezoaktors ändert. Vorzugsweise ändert sich diese Eigenschaft der Gradient-Verkapselungsschicht graduell mit zunehmender Entfernung von der Oberfläche des Piezoaktors.

Gemäß einer bevorzugten Ausführungsform umfasst die Gradient-Verkapselungsschicht angrenzend an die Oberfläche des Piezoaktors einen ersten Bereich elastischen Materialverhaltens und angrenzend an eine Außenseite der Gradient-Verkapselungsschicht einen zweiten Bereich mit chemisch widerstandsfähigem Materialverhalten. Dies wird beispielsweise dadurch erreicht, dass der erste Bereich aus Kunststoff oder einem Kunststoff-Metall-Gemisch und der zweite Bereich aus Metall besteht.

### 4. Beschreibung der begleitenden Zeichnung

Die vorliegende Erfindung wird unter Bezugnahme auf die begleitende Zeichnung näher erläutert. Diese zeigt eine schematische Schnittdarstellung eines Piezoaktors mit Gradient-Verkapselungsschicht gemäß einer bevorzugten Ausführungsform.

### 5. Detaillierte Beschreibung bevorzugter Ausführungsformen

Die Figur zeigt eine schematische Ansicht eines Piezoaktors 1 mit einer Gradient-Verkapselungsschicht 20. Die Gradient-Verkapselungsschicht 20 ist auf die Oberfläche 10 des Piezoaktors 1 aufgebracht. Vorzugsweise erstreckt sie sich auf der Oberfläche 10 des Piezoaktors 1 parallel zu seiner Stapelrichtung 30. Gemäß einer weiteren Alternative ist der Piezoaktor 1 vollständig durch die Gradient-Verkapselungsschicht 20 eingeschlossen.

Die Gradient-Verkapselungsschicht 20 wird mittels Kaltgasspritzen erzeugt. Dieses Verfahren ist eine Form des thermischen Spritzens, bei dem kein Aufschmelzen des Beschichtungsmaterials vor dem Aufbringen auf eine Oberfläche erfolgt. Zum Erzeugen der Gradient-Verkapselungsschicht 20 mittels Kaltgasspritzen wird das Beschichtungsmaterial in Pulverform mit hoher kinetischer Energie auf die Oberfläche 10 des Piezoaktors 1 aufgespritzt. Zu diesem Zweck werden die Ausgangsmaterialien bzw. Werkstoffe der Gradient-Verkapselungsschicht 20 mit bekannten Pulverförderern einem Trägergas zugeführt, so dass das Trägergas die Partikel des Beschichtungsmaterials in Richtung der Oberfläche 10 beschleunigt.

Neben der Bereitstellung der Partikel des Beschichtungsmaterials stellt man mit Hilfe der Pulverförderer ein, in welcher Zusammensetzung die Menge der beschleunigten Pulverpartikel auf die Oberfläche 10 des Piezoaktors 1 trifft. Dies ist von Bedeutung, um die physikalischen und chemischen Eigenschaften der Gradient-Verkapselungsschicht 20 gezielt in unterschiedlichen Tiefenbereichen der Gradient-Verkapselungsschicht 20 einzustellen. Trotz Schichtbildung werden nämlich die chemischen und mechanischen Eigenschaften der Ausgangsmaterialien oder der während des Kaltgasspritzens aufzubringenden Pulverpartikel nicht oder nur geringfügig verändert. Daher stellen sich in Abhängigkeit davon, wie der Anteil an Partikeln der Ausgangsmaterialien bzw. der mindestens zwei Pulver bei der Bildung der Gradient-Verkapselungsschicht 20 gewählt wird, in ausgewählten Bereichen der Gradient-Verkapselungsschicht 20 die entsprechenden durch die Partikel vorgegebenen Eigenschaften ein. Beschichtet man beispielsweise die Oberfläche 10 des Piezoaktors mit Partikeln aus elastischem Kunststoff, entsteht eine Schicht mit elastischen Materialeigenschaften. Diese elastischen Materialeigenschaften lassen sich auch in anderer Konfiguration erzielen, indem man die Oberfläche 10 des Piezoaktors mit Metallpartikeln beschichtet, die eine Kunststoffummantelung aufweisen. Des Weiteren ist bevorzugt, dass Kaltgasspritzen mit einem hohen Anteil oder ausschließlich mit Metallpartikeln vorzunehmen, so dass ein metallischer Bereich in der Gradient-Verkapselungsschicht 20 erzeugt wird, der sich durch ein chemisch isolierendes oder gegen chemischen Angriff resistentes Materialverhalten auszeichnet.

Die Gradient-Verkapselungsschicht 20 auf der Oberfläche 10 des Piezoaktors erfüllt die folgenden Eigenschaften. Direkt angrenzend an den Piezoaktor 1 stellt sie einen elektrisch isolierenden Bereich bereit. Dieser gewährleistet, dass kein Kurzschluss zwischen bis an die Oberfläche 10 des Piezoaktors ragende Innenelektroden stattfindet. Des Weiteren ist der elektrisch isolierende Bereich im Hinblick auf seine Materialeigenschaften derart gestaltet, dass er nicht in mögliche Poren oder Polungsrisse an der Oberfläche 10 des Piezoaktors 1 eindringt. Auf diese Weise verhindert die Gradient-Verkapselungsschicht 20 eine Ausbreitung von Rissen und unterstützt nicht ein dadurch mögliches Versagen des Piezoaktors 1. Es ist des Weiteren bevorzugt, dass die Gradient-Verkapselungsschicht 20 nahe der Oberfläche 10 des Piezoaktors elastische Eigenschaften aufweist. Dies gewährleistet, dass während des Betriebs des Piezoaktors dessen Dehnung senkrecht zur Stapelrichtung 30 mit zunehmender Schichtdicke gedämpft wird und gleichzeitig der Piezoaktor 1 in seinem Betrieb nicht behindert wird.

Wird der Piezoaktor 1 mit Gradient-Verkapselungsschicht 20 beispielsweise im "wet design" eingesetzt, ist er permanent von chemisch aggressivem Kraftstoff umgeben. Um den Piezoaktor 1 vor chemischem Angriff und Beschädigung zu schützen, wird ein metallischer Bereich in der Gradient-Verkapselungsschicht 20 erzeugt. Dieser metallische Bereich bildet die äußere Begrenzung der Gradient-Verkapselungsschicht 20 und somit die Grenzfläche zum umgebenden chemisch aggressiven Medium. Als Beschichtungsmaterial eignen sich Partikel aus Metall(en), die chemisch resistent gegen den Angriff von Kraftstoffen sind. In Abhängigkeit vom umgebenden Medium sowie von der Verarbeitbarkeit ist ein geeignetes Metall wählbar, so dass eine chemische Isolation von Piezoaktor 1 und Gradient-Verkapselungsschicht 20 gegen ein aggressives Medium gewährleistet ist.

Der metallische Bereich an der Außenseite der Gradient-Verkapselungsschicht 20 wird während des Betriebs des Piezoaktors 1 durch dessen Dehnungen belastet, die über die Gradient-Verkapselungsschicht 20 auf den metallischen Bereich übertragen werden. Aus diesem Grund ist die Gradient-Verkapselungsschicht 20 derart konfiguriert, dass die Dehnungen des Piezoaktors bis zum metallischen oder allgemein bis zum chemisch resistenten Bereich so weit gedämpft werden, dass die verbleibende übertragene Restdehnung den metallischen Bereich der Gradient-Verkapselungsschicht 20 nicht beschädigt oder zerstört.

Um die obigen Eigenschaften der Gradient-Verkapselungsschicht 20 zu erzielen, wird sie gemäß der folgenden Ausführungsform hergestellt. Mit Hilfe des oben genannten Kaltgasspritzens werden sphärische Metallpartikel mit und ohne Kunststoffummantelung auf die Oberfläche 10 des Piezoaktors 1 aufgespritzt. Um zunächst einen elastischen und elektrisch isolierenden Bereich auf der Oberfläche 10 des Piezoaktors 1 zu erzeugen, wird eine Partikelmischung mit hohem Anteil an Metallpartikeln mit Kunststoffummantelung aufgespritzt. Die Metallpartikel mit Kunststoffummantelung sind beispielsweise mittels LBL-Technologie (Layer-by-Layer-Technologie) Firma Capsulution NanoScience AG, Berlin, hergestellt. Es ist ebenfalls denkbar, die Oberfläche 10 des Piezoaktors 1 zunächst nur oder mit einem hohen Anteil an Kunststoffpartikeln zu beschichten, um die elastischen und elektrisch isolierenden Eigenschaften der Gradient-Verkapselungsschicht 20 zu erzielen.

Des Weiteren ist es erforderlich, die bereits oben diskutierte Abschwächung der Dehnung des Piezoaktors innerhalb der Gradient-Verkapselungsschicht 20 mit zunehmender Entfernung zur Oberfläche 10 senkrecht zur Stapelrichtung 30 zu erzielen. Zu diesem Zweck wird ein Materialgradient in der Gradient-Verkapselungsschicht 20 derart erzeugt, dass die Steifigkeit der Gradient-Verkapselungsschicht 20 mit zunehmender Entfernung vom Piezoaktor 1 zunimmt. Um eine zunehmende Steifigkeit in der Gradient-Verkapselungsschicht 20 einzustellen, wird die Gradient-Verkapselungsschicht 20 mit sukzessive zunehmendem Anteil an Metallpartikeln ohne Kunststoffummantelung mit zunehmender Schichtdicke erzeugt. Es ist ebenfalls denkbar, Partikel aus anderen Werkstoffen zu nutzen, die durch ihr Beimischen eine mechanisch versteifende Wirkung auf die Gradient-Verkapselungsschicht 20 haben. Eine Alternative ist das Beschichten mit Keramikpartikeln.

Bei der Erzeugung der Gradient-Verkapselungsschicht 20 wird daher der Anteil der genutzten Partikel in Abhängigkeit von deren Werkstoffeigenschaften derart verändert, dass sich ein Eigenschaftsgradient über die Schichtdicke d der Gradient-Verkapselungsschicht 20 ergibt. Daher nimmt bevorzugt die Steifigkeit der Gradient-Verkapselungsschicht 20 mit zunehmender Entfernung von der Oberfläche 10 des Piezoaktors zu. Des Weiteren nimmt beispielsweise die elektrische Leitfähigkeit mit zunehmender Entfernung von der Oberfläche 10 zu, wenn Metallpartikel ohne Kunststoffummantelung als versteifende Partikel beigemischt werden. Die chemische Widerstandsfähigkeit nimmt bevorzugt von außen nach innen ab, wenn an der Außenseite der Gradient-Verkapselungsschicht 20 ein metallischer Bereich einen überwiegenden Anteil an Metall aufweist oder ausschließlich durch Metallpartikel gebildet wird und der Anteil an Metallpartikeln bei der Schichtbildung in Richtung des Piezoaktors 1 abnimmt.

Im Vergleich zu bisher genutzten Verkapselungsmethoden von Piezoaktoren 1 ergibt sich eine kompaktere Anordnung, die zudem eine minimale Dämpfung des Dehnungsverhaltens in Stapelrichtung 30 während des Betriebs des Piezoaktors 1 hervorruft. Des Weiteren liegt ein einfacheres Design vor, das weder eine Metallverkapselung noch ein Druckübertragungsmedium zwischen Piezoaktor 1 und Metallverkapselung erfordert. Ein weiterer Vorteil besteht darin, dass das obige Beschichtungsverfahren im Vergleich zum Einbau von Piezoaktoren in Metallverkapselungen geringen Zeit- und Materialaufwand erfordert.

Somit wird durch das obige Herstellungsverfahren ein Piezoaktor 1 mit Gradient-Verkapselungsschicht 20 bereitgestellt, innerhalb derer sich mindestens eine chemische und physikalische Eigenschaft graduell mit zunehmender Entfernung von der Oberfläche 10 des Piezoaktors 1 ändert. Bevorzugt umfasst diese Gradient-Verkapselungsschicht 20 angrenzend an die Oberfläche des Piezoaktors einen ersten Bereich elastischen Materialverhaltens, vorzugsweise aus Kunststoff oder einem Kunststoff-Metall-Gemisch, und angrenzend an die Außenseite der Gradient-Verkapselungsschicht 20 einen zweiten Bereich mit chemisch widerstandsfähigem Materialverhalten, vorzugsweise aus Metall oder einem vergleichbar chemisch resistenten Material.

## Patentansprüche

1. Herstellungsverfahren einer Gradient-Verkapselungsschicht (20) eines Piezoaktors (1), so dass der Piezoaktor (1) ohne zusätzliche gehäuseartige umhüllende Struktur nach außen geschützt ist, das die folgenden Schritte aufweist:
a. Beladen eines ersten Pulverförderers mit ersten Partikeln aus einem ersten Werkstoff, der gegenüber einem ausgewählten Medium chemisch resistent ist,
b. Beladen eines zweiten Pulverförderers mit zweiten Partikeln aus einem zweiten Werkstoff, der elastische Materialeigenschaften besitzt,
c. thermisches Spritzen, insbesondere Kaltgasspritzen der ersten und zweiten Partikel mit Hilfe des ersten und zweiten Pulverförderers auf eine Oberfläche (10) des Piezoaktors (1) derart, dass die Gradient-Verkapselungsschicht (20) entsteht.

2. Herstellungsverfahren gemäß Anspruch 1, mit dem weiteren Schritt:
Verändern eines Anteils an ersten Partikeln und/oder eines Anteils an zweiten Partikeln während des Kaltgasspritzens, so dass in der Gradient-Verkapselungsschicht (20) in Abhängigkeit von deren Schichtdicke eine chemische und/oder physikalische Materialeigenschaft der ersten und/oder zweiten Partikel eine chemische und/oder physikalische Schichteigenschaft bestimmt und sich diese Schichteigenschaft mit der Schichtdicke der Gradient-Verkapselungsschicht (20) ändert.

3. Herstellungsverfahren gemäß Anspruch 1 oder 2, mit dem weiteren Schritt:
Kaltgasspritzen von Metallpartikeln, vorzugsweise sphärische Metallpartikel, als erste Partikel derart, dass an einer Außenseite der Gradient-Verkapselungsschicht (20) ein chemisch resistenter metallischer Bereich entsteht.

4. Herstellungsverfahren gemäß einem der vorhergehenden Ansprüche, mit dem weiteren Schritt:
Kaltgasspritzen von Metallpartikeln mit Kunststoffummantelung oder Kunststoffpartikeln als zweite Partikel derart, dass an einer Innenseite der Gradient-Verkapselungsschicht (20) angrenzend an den Piezoaktor (1) ein elastischer und/oder elektrisch isolierender Bereich entsteht.

5. Herstellungsverfahren gemäß einem der vorhergehenden Ansprüche, mit dem weiteren Schritt:
Kaltgasspritzen von mindestens dritten Partikeln, so dass eine Werkstoffeigenschaft der dritten Partikel in Abhängigkeit von deren Anteil in der Gradient-Verkapselungsschicht (20) gezielt in einem Schichtdickenbereich der Gradient-Verkapselungsschicht (20) als Schichteigenschaft generierbar ist.

6. Piezoaktor (1) mit Gradient-Verkapselungsschicht (20), insbesondere ein Vielschichtaktor, so dass der Piezoaktor (1) ohne zusätzliche gehäuseartige umhüllende Struktur nach außen geschützt ist, der die folgenden Merkmale aufweist:
a. einen Piezoaktor (1), vorzugsweise einen Vielschichtaktor,
b. die auf einer äußeren Oberfläche (10) des Piezoaktors (1) aufgebrachte Gradient-Verkapselungsschicht (20), die mindestens eine chemische und/oder physikalische Eigenschaft aufweist, die sich mit zunehmender Entfernung von der Oberfläche des Piezoaktors (10) ändert.

7. Piezoaktor (1) mit Gradient-Verkapselungsschicht (20) gemäß Anspruch 6, wobei sich die mindestens eine chemische und/oder physikalische Eigenschaft der Gradient-Verkapselungsschicht (20) graduell mit zunehmender Entfernung von der Oberfläche (10) des Piezoaktors (1) ändert.

8. Piezoaktor (1) mit Gradient-Verkapselungsschicht (20) gemäß Anspruch 6 oder 7, dessen Gradient-Verkapselungsschicht (20) angrenzend an die Oberfläche (10) des Piezoaktors (1) einen ersten Bereich elastischen Materialverhaltens und angrenzend an eine Außenseite der Gradient-Verkapselungsschicht (20) einen zweiten Bereich mit chemisch widerstandsfähigem Materialverhalten aufweist.

9. Piezoaktor (1) mit Gradient-Verkapselungsschicht (20) gemäß Anspruch 8, dessen erster Bereich aus Kunststoff oder einem Kunststoff-Metall-Gemisch und dessen zweiter Bereich aus Metall bestehen.

10. Piezoaktor (1) mit Gradient-Verkapselungsschicht (20) gemäß einem der Ansprüche 6 bis 9, dessen Gradient-Verkapselungsschicht (20) die Seitenflächen des Piezoaktors (1) parallel zu dessen Stapelrichtung oder seine gesamte Oberfläche bedeckt.

## Claims

1. Production method for a gradient encapsulation layer (20) of a piezo actuator (1), so that the piezo actuator (1) is protected externally without an additional housing-like enveloping structure, which method exhibits the following steps:
a. loading of a first powder conveyor with first particles of a first material which is chemically resistant to a selected medium,
b. loading of a second powder conveyor with second particles of a second material which possesses elastic material properties,
c. thermal spraying, in particular cold gas spraying of the first and second particles using the first and second powder conveyor onto a surface (10) of the piezo actuator (1) in such a way that the gradient encapsulation layer (20) is formed.

2. Production method according to claim 1 with the further step:
A proportion of first particles and/or a proportion of second particles is changed during cold gas spraying so that in the gradient encapsulation layer (20) as a function of its layer thickness a chemical and/or physical material property of the first and/or second particles determines a chemical and/or physical layer property and this layer property changes with the layer thickness of the gradient encapsulation layer (20).

3. Production method according to claim 1 or 2 with the further step:
Cold gas spraying of metal particles, preferably spherical metal particles, as first particles in such a way that a chemically resistant metallic area is formed on an outer side of the gradient encapsulation layer (20).

4. Production method according to one of the preceding claims with the further step:
Cold gas spraying of plastic-coated metal particles or plastic particles as second particles in such a way that an elastic and/or electrically insulating area is formed on an inner side of the gradient encapsulation layer (20) at the interface with the piezo actuator (1).

5. Production method according to one of the preceding claims with the further step:
Cold gas spraying of at least third particles so that a material property of the third particles can be generated as a function of their proportion in the gradient encapsulation layer (20) specifically in one layer thickness area of the gradient encapsulation layer (20) as a layer property.

6. Piezo actuator (1) with gradient encapsulation layer (20), in particular a multilayer actuator, so that the piezo actuator (1) is protected externally without an additional housing-like enveloping structure, which exhibits the following features:
a. a piezo actuator (1) preferably a multilayer actuator,
b. the gradient encapsulation layer (20) applied to an outer surface (10) of the piezo actuator (1) which exhibits at least one chemical and/or physical property which changes with increasing distance from the surface of the piezo actuator (10).

7. Piezo actuator (1) with gradient encapsulation layer (20) according to claim 6, in which the at least one chemical and/or physical property of the gradient encapsulation layer (20) changes gradually with increasing distance from the surface (10) of the piezo actuator (1).

8. Piezo actuator (1) with gradient encapsulation layer (20) according to claim 6 or 7, whose gradient encapsulation layer (20) at the interface with the surface (10) of the piezo actuator (1) exhibits a first area of elastic material behaviour and at the interface with an outer side of the gradient encapsulation layer (20) exhibits a second area with chemically resistant material behaviour.

9. Piezo actuator (1) with gradient encapsulation layer (20) according to claim 8, whose first area is made of plastic or a plastic-metal mixture and whose second area is made of metal.

10. Piezo actuator (1) with gradient encapsulation layer (20) according to one of claims 6 to 9, whose gradient encapsulation layer (20) covers the side faces of the piezo actuator (1) parallel to its stack direction or its entire surface.

## Revendications

1. Procédé de fabrication d'une couche d'encapsulation à gradient (20) d'un piézoactionneur (1) de sorte que le piézoactionneur (1) soit protégé vers l'extérieur sans structure enveloppante supplémentaire de type boîtier, comprenant les étapes suivantes :
a. charger un premier convoyeur de poudre de premières particules en un premier matériau chimiquement résistant à un milieu sélectionné,
b. charger un deuxième convoyeur de poudre de deuxièmes particules en un deuxième matériau possédant des propriétés élastiques,
c. projection thermique, en particulier projection par gaz froid des premières et deuxièmes particules, à l'aide du premier et deuxième convoyeur de poudre, sur une surface (10) du piézoactionneur (1) de telle sorte que la couche d'encapsulation à gradient (20) se forme.

2. Procédé de fabrication selon la revendication 1, comprenant l'étape supplémentaire suivants :
modifier une fraction des premières particules et/ou une fraction des deuxièmes particules pendant la projection par gaz froid de sorte que dans la couche d'encapsulation à gradient (20), en fonction de l'épaisseur de couche de celle-ci, une propriété chimique et/ou physique du matériau des premières et/ou deuxièmes particules détermine une propriété chimique et/ou physique de la couche et que cette propriété de la couche change avec l'épaisseur de couche de la couche d'encapsulation à gradient (20).

3. Procédé de fabrication selon la revendication 1 ou 2, comprenant l'étape supplémentaire suivants :
projection par gaz froid de particules métalliques, de préférence de particules métalliques sphériques, en tant que premières particules de sorte qu'une zone métallique chimiquement résistante se forme sur une face externe de la couche d'encapsulation à gradient (20).

4. Procédé de fabrication selon l'une des revendications précédentes, comprenant l'étape supplémentaire suivants :
projection par gaz froid de particules métalliques enrobées de matière plastique ou de particules de matière plastique en tant que deuxièmes particules de telle sorte qu'une zone élastique et/ou électriquement isolante, contiguë au piézoactionneur (1), se forme sur une face interne de la couche d'encapsulation à gradient (20).

5. Procédé de fabrication selon l'une des revendications précédentes, comprenant l'étape supplémentaire suivants :
projection par gaz froid au moins de troisièmes particules de sorte qu'une propriété du matériau des troisièmes particules, en fonction du taux de celles-ci dans la couche d'encapsulation à gradient (20), puisse être générée de manière ciblée comme propriété de la couche dans une zone d'épaisseur de couche de la couche d'encapsulation à gradient (20).

6. Piézoactionneur (1) doté d'une couche d'encapsulation à gradient (20), en particulier un actionneur multicouche, de sorte que le piézoactionneur (1) soit protégé vers l'extérieur sans structure enveloppante supplémentaire de type boîtier, comprenant les caractéristiques suivantes :
a. un piézoactionneur (1), de préférence un actionneur multicouche,
b. la couche d'encapsulation à gradient (20) appliquée sur une surface extérieure (10) du piézoactionneur (1), et présentant au moins une propriété chimique et/ou physique qui change avec l'éloignement croissant de la surface (10) du piézoactionneur (1).

7. Piézoactionneur (1) doté d'une couche d'encapsulation à gradient (20) selon la revendication 6, dans lequel ladite au moins une propriété chimique et/ou physique de la couche d'encapsulation à gradient (20) change graduellement avec l'éloignement croissant de la surface (10) du piézoactionneur (1).

8. Piézoactionneur (1) doté d'une couche d'encapsulation à gradient (20) selon la revendication 6 ou 7, dont la couche d'encapsulation à gradient (20), contiguë à la surface (10) du piézoactionneur (1), présente une première zone à comportement élastique du matériau et, contiguë à une face externe de la couche d'encapsulation à gradient (20), une deuxième zone à comportement chimiquement résistant du matériau.

9. Piézoactionneur (1) doté d'une couche d'encapsulation à gradient (20) selon la revendication 8, dont la première zone est constituée de matière plastique ou d'un mélange matière plastique/métal, et dont la deuxième zone est en métal.

10. Piézoactionneur (1) doté d'une couche d'encapsulation à gradient (20) selon l'une des revendications 6 à 9, dont la couche d'encapsulation à gradient (20) recouvre les faces latérales du piézoactionneur (1) parallèlement au sens d'empilage de celui-ci, ou l'ensemble de sa surface.
